# EUROPÄISCHE PATENTSCHRIFT

(11) **EP 2 630 668 B1**
(45) Veröffentlichungstag und Bekanntmachung des Hinweises auf die Patenterteilung: **05.05.2021**
(21) Anmeldenummer: 11764159.7
(22) Anmeldetag: 28.09.2011
(51) Int. Cl.: H01L 33/50

(54) **VERFAHREN ZUR HERSTELLUNG EINES KONVERSIONSPLÄTTCHENS**
METHOD OF FABRICATING A WAVELENGTH-CONVERSION PLATE
PROCÉDÉ DE FABRICATION D'UNE PLAQUETTE DE CONVERSION

(30) Priorität: 22.10.2010 DE 102010049312
(43) Veröffentlichungstag der Anmeldung: 28.08.2013
(73) Patentinhaber: OSRAM Opto Semiconductors GmbH, 93055 Regensburg (DE)
(72) Erfinder: RICHTER, Markus, 93133 Burglengenfeld (DE)
(74) Vertreter: Epping - Hermann - Fischer
(86) Internationale Anmeldenummer: PCT/EP2011/066905
(87) Internationale Veröffentlichungsnummer: WO 2012/052271

(56) Entgegenhaltungen:
- EP-A1- 1 681 728
- EP-A1- 2 216 834
- EP-A2- 1 198 016
- WO-A1-2006/121196
- WO-A1-2009/148176
- WO-A2-2006/126119
- WO-A2-2008/060586
- JP-A- 2001 277 745
- JP-A- 2010 228 320
- US-A1- 2005 146 879
- US-A1- 2009 278 151

## Beschreibung

Die Erfindung betrifft ein Verfahren zum Herstellen eines Konversionsplättchens für ein strahlungsemittierendes Halbleiterbauelement gemäß Patentanspruch 1.

Herkömmlicherweise werden Konversionsplättchen unter anderem mittels eines Siebdruckverfahrens hergestellt. Dabei wird die Schichtdicke der Konversionsplättchen durch eine Auswahl von Sieben mit unterschiedlich dicken Masken gesteuert. Die Schichtdicken so hergestellter Konversionsplättchen sind dabei jedoch im Siebdruckverfahren auf etwa 40 µm limitiert. Bei Konversionsplättchen, die mittels eines Siebdruckverfahrens hergestellt sind, kann zudem die Kontur der Plättchen sowie die Reproduzierbarkeit ihrer Abmessungen und Formen nachteilig schwanken.

In der Druckschrift US 2005/0146879 A1 wird eine LED Lampe und eine Methode, um diese herzustellen, angegeben.

Die Druckschrift EP 1 681 728 A1 offenbart ein lichtemittierendes Bauelement, das ein Konversionselement aufweist.

Die Druckschrift US 2009/0278151 A1 beschreibt Bündel lichtemittierender Dioden, Systeme aus lichtemittierenden Dioden und Methoden diese herzustellen.

Die Druckschrift WO 2006/121196 A1 offenbart eine LED mit einer Leuchtstoffschicht, die verschiedene Dicken oder verschiedene Leuchtstoffkonzentrationen aufweist.

In der Druckschrift EP 1 198 016 A2 werden schablonierte Leuchtstoffschichten auf lichtemittierenden Dioden beschrieben.

Die Druckschrift WO 2006/126119 A2 beschreibt eine Elektrolumineszenzvorrichtung.

In der Druckschrift WO 2008/060586 A2 ist eine lichtemittierende Diode offenbart.

In der Druckschrift WO 2009/148176 A1 ist eine Halbleiter-Lichtemissionsvorrichtung beschrieben.

Die Druckschrift JP 2010-228320 A beschreibt eine Herstellung einer Halbleitervorrichtung.

In der Druckschrift JP 2001-277745 A ist eine Siebdruckplatte und ein Verfahren zur Herstellung gezeigt.

Die Druckschrift EP 2 216 834 B1 offenbart eine lichtemittierende Vorrichtung.

Der Erfindung liegt die Aufgabe zugrunde, ein Verfahren zum Herstellen eines Konversionsplättchens mit hoher Schichtdicke und gleichzeitig verbesserte Reproduzierbarkeit sowie verbesserter Kantentreuer anzugeben.

Diese Aufgabe wird unter anderem durch ein Verfahren zum Herstellen eines Konversionsplättchens mit den Merkmalen des Anspruchs 1 gelöst. Vorteilhafte Weiterbildungen des Verfahrens zu dessen Herstellung sind Gegenstand der abhängigen Ansprüche.

Erfindungsgemäß ist ein Verfahren zur Herstellung zumindest eines Konversionsplättchens für ein strahlungsemittierendes Halbleiterbauelement vorgesehen, bei dem ein Grundmaterial mit darin enthaltenem Konversionsstoff mittels einer doppelschichtigen Schablone auf ein Substrat aufgebracht wird.

Das Konversionsplättchen wird also nicht wie üblicherweise mit einem Siebdruckverfahren hergestellt, sondern mittels einer doppelschichtigen Schablone aufgebracht. Die doppelschichtige Schablone ist dabei aufgrund ihrer variablen Dicke zur Herstellung von besonders dicken Konversionsplättchen geeignet. Herkömmlicherweise verwendete Siebe sind dagegen aufgrund ihrer geringen Dicken von höchstens 40 µm auf diese beschränkt, sodass mit herkömmlichen Herstellungsverfahren keine hohen Schichtdicken der Konversionsplättchen erzielt werden können.

Zudem kann vorteilhafterweise durch eine entsprechende Optimierung des Designs der Schablone, wie beispielsweise Apertur, Form und Größe auf die Form des Konversionsplättchens Einfluss genommen werden.

Weiter wird durch das Herstellungsverfahren mittels der doppelschichtigen Schablone die Kontur der Plättchen und die Reproduzierbarkeit ihrer Abmessungen verbessert.

Die erhöhte Schichtdicke der so hergestellten Konversionsplättchen zeichnet sich durch ein großes Konversionsstoffvolumen aus. Dadurch ist es möglich, unter anderem Farborte anzusteuern, die mit konventioneller Technologie nicht realisierbar sind. Weiter ermöglicht die erhöhte Plättchendicke den Einsatz von Konversionsstoffen, die speziell in ihren Eigenschaften, wie beispielsweise Effizienz, Temperatur oder Langzeitstabilität, optimiert sind.

Unter dem Farbort werden insbesondere die Zahlenwerte verstanden, die Farbe der emittierten Strahlung des Bauelements im CIE-Farbraum beschreiben.

Der Konversionsstoff ist insbesondere geeignet, Strahlung einer Wellenlänge in Strahlung einer anderen Wellenlänge zu konvertieren. Konversionsplättchen mit derartigen Konversionsstoffen finden Verwendung für beispielsweise strahlungsemittierende Halbleiterbauelemente, wobei in diesem Fall die Konversionsplättchen einer Strahlungsaustrittsseite des Halbleiterbauelements nachgeordnet sind und dazu ausgerichtet sind, zumindest einen Teil der von den Halbleiterbauelementen emittierte Strahlung in Strahlung einer anderen Wellenlänge umzuwandeln.

In einer Weiterbildung ist die doppelschichtige Schablone in einem zweistufigen lithographischen und Nickel-galvanischen Verfahren hergestellt. Dadurch bildet sich eine zweischichtige Struktur der Schablone aus, wobei die zwei Strukturen der Schablone vorteilhalfterweise aus demselben Material bestehen. Die zweite Schicht bestimmt dabei beispielsweise Dicke und Gestalt bzw. Form der zu druckenden Strukturen, also der Konversionsplättchen. Die zweischichtige Schablone ist insbesondere besonders geeignet für Anwendungen, bei denen es auf eine hohe Genauigkeit ankommt und bietet vorteilhafterweise eine hohe Lebensdauer. Zudem ermöglicht sie den Druck feiner Linien und Strukturen unterschiedlicher Größe.

In einer Weiterbildung enthält die Schablone Nickel. Bevorzugt besteht die Schablone aus nur einem Material, beispielsweise Nickel. Dadurch kann mit Vorteil das Grundmaterial für das Konversionsplättchen optimal an gewünschte Anforderungen angepasst werden. Durch die Möglichkeit des Einsatzes eines optimierten Grundmaterials kann unter anderem zudem eine bessere Druckbarkeit erzielt werden, wodurch die Reproduzierbarkeit und Kontur der Plättchen verbessert werden können.

In einer Weiterbildung wird das Grundmaterial mit darin enthaltenem Konversionsstoff mittels eines Druckverfahrens aufgebracht.

Dabei wird das Grundmaterial mit darin enthaltenem Konversionsstoff durch die Schablone gedrückt, sodass das Grundmaterial die Struktur der Schablone im Wesentlichen übernimmt. Durch eine entsprechende Optimierung des Designs der Struktur der Schablone, wie beispielsweise Form und Größe, kann so auf die Form des Konversionsplättchens Einfluss genommen werden, diese insbesondere bestimmen.

In einer Weiterbildung weist die Schablone zumindest einen Durchbruch auf, durch den das Grundmaterial mit darin enthaltenem Konversionsstoff auf das Substrat aufgedrückt wird. Die Form des Durchbruchs bestimmt dabei die Form des herzustellenden Konversionsplättchens.

In einer Weiterbildung weist die Schablone eine Druckseite und eine Auflageseite auf. Die Auflageseite ist dabei dem Substrat zugewandt, die Druckseite ist vom Substrat abgewandt.

In einer Weiterbildung weist die Druckseite eine Nickelgewebestruktur auf. Durch die Nickelgewebestruktur kann mit Vorteil eine Planarität des gedruckten Plättchens gewährleistet werden. So können vorteilhafterweise plane Strukturen des Konversionsplättchen erzeugt werden. Die Nickelgewebestruktur kann zudem auf die zu druckenden Strukturen hin optimiert werden, womit die Schablone vorteilhafterweise zur Verbesserung der Kantentreue und der Reproduzierbarkeit der Plättchenabmessungen beitragen kann.

In einer Weiterbildung wird das Grundmaterial mit darin enthaltenem Konversionsstoff auf der Druckseite aufgebracht und anschließend durch die Schablone mittels einer Druckrakel auf das Substrat aufgedrückt. Das Grundmaterial wird somit auf der von dem Substrat abgewandten Seite der Schablone aufgebracht und derart durch den Durchbruch oder die Durchbrüche der Schablone mittels Drucks gepresst, sodass das Grundmaterial nach dem Druckvorgang in dem Durchbruch oder den Durchbrüchen der Schablone angeordnet ist. Die Druckseite ist bevorzugt nach dem Druckverfahren zum größten Teil frei von Grundmaterial.

In einer Weiterbildung wird durch die Form des Durchbruchs auf der Auflageseite die Form des Konversionsplättchens bestimmt. Hierbei kann der Durchbruch in vertikaler Richtung, also senkrecht in Richtung Substrat, unterschiedliche Ausdehnungen und Formen aufweisen. Die Form des Konversionsplättchens wird dabei von der Form des Durchbruchs auf der Auflageseite bestimmt.

In einer Weiterbildung weist der Durchbruch auf der Druckseite eine Gitterstruktur auf. Die Gitterstruktur erhöht mit Vorteil die Stabilität der Schablone. Der Durchbruch weist in diesem Fall somit zwei Bereiche auf, die vertikal übereinander angeordnet sind, wobei der dem Substrat zugewandte Bereich die Form des herzustellenden Konversionsplättchens wiedergibt und der von dem Substrat abgewandte Bereich zur Stabilisierung der Schablone eine Gitterstruktur aufweist. Die Schablone besteht trotz dieses zweischichtigen Aufbaus vorzugsweise aus lediglich einem Material, bevorzugt Nickel.

In einer Weiterbildung wird die Schablone zum Aufbringen des Grundmaterials in direktrem Kontakt mit dem Substrat angeordnet. Zwischen Schablone und Substrat ist somit während des Druckvorgangs kein Abstand vorhanden. Das Grundmaterial wird dabei während des Druckvorgangs in die Durchbrüche bis zum Substrat gedrückt, sodass das Grundmaterial vorzugsweise nach dem Druckprozess die Durchbrüche vollständig ausfüllt. Nach dem Druckvorgang entspricht die Höhe der Durchbrüche also etwa der Höhe des darin angeordneten Grundmaterials.

Nach dem Druckvorgang wird die Schablone von dem Substrat derart gelöst, dass auf der Schablone lediglich das Grundmaterial mit darin enthaltenem Konversionsstoff zurückbleibt.

In einer Weiterbildung wird das Konversionsplättchen mit einer Dicke zwischen einschließlich 60 µm und einschließlich 170 µm hergestellt. Derartige Dicken können beispielsweise bei herkömmlicherweise verwendeten Siebdruckverfahren nicht erzielt werden. Aufgrund der erhöhten schichtdicke kann mit Vorteil für die Lichtkonversion ein großes Konversionsstoffvolumen ermöglicht werden. Dadurch erhöht sich mit Vorteil die Möglichkeit der Ansteuerung eines breiten Spektrums an Farborten.
Durch die erhöhte Plättchendicke kann auch der Einsatz von Konversionsstoffen ermöglicht werden, deren benötigte Menge herkömmlicherweise bei dünneren Konversionsplättchen die Grenzen der Feststoffbeladung im Plättchen übersteigen würde. Diese weiteren Konversionsstoffe können speziell angepasste Eigenschaften bezüglich ihrer Effizienz, Temperaturbeständigkeit und Langzeitstabilität aufweisen.

In einer Weiterbildung wird in einem gemeinsamen Verfahren eine Mehrzahl von Konversionsplättchen hergestellt, die in einem gemeinsamen Verfahrensschritt auf das Substrat mittels Druckverfahrens aufgebracht werden. Dazu weist bevorzugt die Schablone eine Mehrzahl von Durchbrüchen auf, durch die jeweils die Form eines Konversionsplättchens bestimmt wird.

Das Grundmaterial wird dabei im Herstellungsverfahren auf der Druckseite der Schablone über alle Durchbrüche angeordnet und anschließend mit einer Druckrakel durch alle Durchbrüche durchgedrückt, sodass die Durchbrüche vorzugsweise vollständig mit dem Grundmaterial gefüllt sind. Anschließend wird die Schablone von dem Substrat abgehoben, wobei so auf dem Substrat eine Mehrzahl von Konversionsplättchen hergestellt sind, die in ihrer Anordnung der Struktur der Schablone entsprechen.

Die Schablone weist beispielsweise eine Dicke zwischen 80 µm und 150 µm auf. Bevorzugt weist die Schablone eine Dicke zwischen 100 µm und 110 µm auf. Auf der von dem Substrat abgewandten Seite der Schablone kann ein Rahmen angeordnet sein, der die Schablone einspannt.

Das Substrat ist vorzugsweise ein Foliensubstrat, das auf einem Chuck, also einer Spannvorrichtung, angeordnet ist. Das Substrat sowie das hergestellte Konversionsplättchen sind bevorzugt frei von einem strahlungsemittierenden Halbleiterbauelement. Mit anderen Worten wird das Konversionsplättchen nicht unmittelbar auf einem Halbleiterbauelement aufgebracht oder unmittelbar an diesem erzeugt. Das Konversionsplättchen ist dazu eingerichtet, erst nach der fertigen Herstellung auf einem Halbleiterbauelement angebracht zu werden, zum Beispiel aufgeklebt zu werden.

Ein Konversionsplättchen, das mittels des oben beschriebenen Verfahrens hergestellt ist, ist insbesondere für ein strahlungsemittierendes Halbleiterbauelement geeignet. Das Konversionsplättchen weist ein Grundmaterial und einen darin eingebetteten Konversionsstoff auf, wobei die Dicke des Konversionsplättchens in einem Bereich zwischen einschließlich 60 µm und einschließlich 170 µm liegt. Vorzugsweise liegt die Schichtdicke des Plättchens zwischen 90 µm und 110 µm.

Vorzugsweise weist die Schablone auf der Druckseite eine Nickelgewebestruktur auf. Aufgrund der im Herstellungsverfahren verwendeten Schablone mit einer Nickelgewebestruktur kann die Oberfläche des Plättchens eine Maschenstruktur aufweisen.

Konversionsplättchen, die mit dem oben beschriebenen Verfahren hergestellt sind, zeichnen sich insbesondere durch eine Reproduzierbarkeit der Abmessungen sowie eine Verbesserung der Kantentreue aus, sodass Abweichungen zwischen den Konversionsplättchen bezüglich ihrer Abmessungen und Kanten im Wesentlichen nicht oder kaum auftreten.

Herstellungsbedingte geringe Abweichungen sind dabei unbeachtlich zu lassen.
In einer Weiterbildung des Konversionsplättchens beträgt der Anteil des Konversionsstoffs im Grundmaterial zwischen 55 Gew.-% und 70 Gew.-%. Die Konversionsplättchen zeichnen sich also durch eine große Dichte des Konversionsstoffs aus, wodurch es möglich ist, in Verbindung mit strahlungsemittierenden Halbleiterbauelementen eine große Anzahl von Farborten anzusteuern.

In einer Weiterbildung enthält das Grundmaterial Silikon. Das Konversionsplättchen ist also ein konversionsstoffhaltiges Silikon.

Die mit dem Verfahren hergestellten Konversionsplättchen können nach ihrer Herstellung mit strahlungsemittierenden Halbleiterbauelementen kombiniert werden. Insbesondere können derartige Plättchen auf strahlungsemittierende Bauelemente direkt aufgebracht werden.

Als strahlungsemittierende Bauelemente kommen dabei beispielsweise LEDs oder Dünnfilm-LEDs in Frage, die geeignet sind, elektromagnetische Strahlung zu emittieren. Durch geeignete Kombination der hergestellten Konversionsplättchen mit den strahlungsemittierenden Halbleiterbauelementen können so Vorrichtungen erzielt werden, die Mischstrahlung eines gewünschten Farborts emittieren.

Vorteilhafte Weiterbildungen des Konversionsplättchens ergeben sich analog zu den vorteilhaften Weiterbildungen des Herstellungsverfahrens und umgekehrt.

Weitere Merkmale, Vorteile, Weiterbildungen und Zweckmäßigkeiten des Konversionsplättchen und dessen Verfahren ergeben sich aus den im Folgenden in Verbindung mit den Figuren 1 bis 4 erläuterten Ausführungsbeispielen. Es zeigen:
- Figuren 1A bis 1C: jeweils Verfahrensschritte zur Herstellung einer Mehrzahl von Konversionsplättchen gemäß einem ersten Ausführungsbeispiel,
- Figuren 2A bis 2C: jeweils eine schematische Ansicht einer Schablone zur Herstellung einer Mehrzahl von Konversionsplättchen gemäß einem weiteren Ausführungsbeispiel,
- Figuren 3A, 3B: jeweils eine Aufsicht auf ein Konversionsplättchen hergestellt nach dem erfindungsgemäßen Verfahren (Figur 3A) beziehungsweise nach dem Stand der Technik (3B), und
- Figuren 4A, 4B: jeweils eine Aufsicht auf eine Mehrzahl von Konversionsplättchen hergestellt nach dem erfindungsgemäßen Verfahren (4A) beziehungsweise nach dem Stand der Technik (Figur 4B).

Gleiche oder gleich wirkende Bestandteile sind jeweils mit den gleichen Bezugszeichen versehen. Die dargstellten Bestandteile sowie die Größenverhältnisse der Bestandteile untereinander sind nicht als maßstabsgerecht anzusehen.

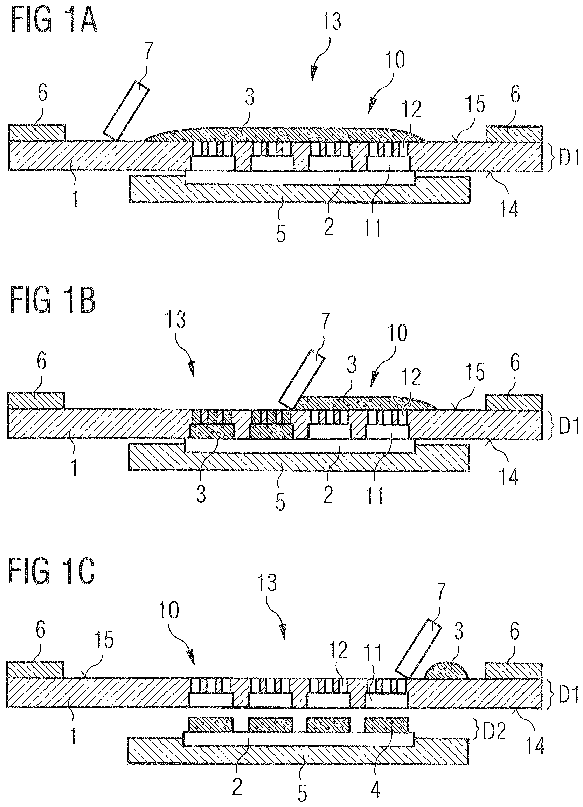

In den Figuren 1A bis 1C sind Verfahrensschritte zur Herstellung einer Mehrzahl von Konversionsplättchen gezeigt.

Derartig hergestellte Konversionsplättchen sind insbesondere zur Verwendung in Kombination mit strahlungsemittierenden Halbleiterbauelementen, wie beispielsweise LEDs, geeignet. Dabei sind die Konversionsplättchen geeignet, eine von dem strahlungsemittierenden Halbleiterbauelement emittierte Strahlung zumindest teilweise in Strahlung einer anderen Wellenlänge umzuwandeln, sodass ein Halbleiterbauelement mit darauf angeordnetem Konversionsplättchen eine Mischstrahlung aus emittierter Strahlung und konvertierter Strahlung aufweist. Die hergestellten Konversionsplättchen werden dabei beispielsweise direkt einer Strahlungsaustrittsseite des Halbleiterbauelements nachgeordnet, beispielsweise direkt auf einer Strahlungsaustrittsfläche befestigt.

Zur Herstellung der Konversionsplättchen findet insbesondere eine Schablone 1 Verwendung. Die Schablone 1 weist eine Dicke D₁ in einem Bereich zwischen 80 µm und 150 µm, bevorzugt zwischen 100 µm und 110 µm auf. Die Schablone weist zur Ausformung der Konversionsplättchen Durchbrüche 10 auf. Die Durchbrüche 10 weisen dabei zwei Bereiche auf, einen formgebenden Bereich 11 und eine Gitterstruktur 12. Die Bereiche der Durchbrüche 11 sind dabei in vertikaler Richtung übereinander angeordnet, das heißt senkrecht zur lateralen Ausdehnung der Schablone 1. Die Gitterstruktur 12 und die formgebende Struktur 11 der Durchbrüche 10 sind derart ausgebildet, dass diese ineinander übergehen. Das bedeutet, dass zwischen der Gitterstruktur 12 und der formgebenden Struktur 11 insbesondere kein Schablonenmaterial angeordnet ist, sodass die Ausnehmungen der Gitterstruktur 12 und die Ausnehmungen der formgebenden Struktur 11 so ineinander übergehen, dass die Schablone in diesen Bereichen vollständig durchbrochen ist.

Zur Herstellung einer Mehrzahl von Konversionsplättchen weist die Schablone 1 eine Mehrzahl von Durchbrüchen 10 auf, die vorzugsweise identisch oder nahezu identisch ausgebildet sind. Die Durchbrüche 10 sind dabei beispielsweise matrixartig in der Schablone angeordnet. Die Durchbrüche 10 weisen somit in lateraler Richtung jeweils einen Abstand zu einem benachbarten Durchbruch auf, wobei der Abstand mit Schablonenmaterial gefüllt ist.

Die formgebende Struktur 11 bestimmt insbesondere die Form der herzustellenden Konversionsplättchen. Abhängig von der Ausgestaltung der formgebenden Struktur 11 werden somit die Konversionsplättchen ausgebildet. Die Größe und Gestalt sowie die Höhe der Konversionsplättchen sind so vorgegeben.

Die Gitterstrukturen 12 halten die Schablone vorteilhafterweise stabil und steuern mit Vorteil präzise das Material der herzustellenden Konversionsplättchen zur formgebenden Struktur 11.

Die doppelschichtige Schablone 11 wird vorzugsweise in einem zweistufigen lithografischen und nickelgalvanischen Verfahren hergestellt und anschließend in einem Spannrahmen 6 montiert. Die Schablone 1 besteht vorzugsweise aus lediglich einem Material, beispielsweise Nickel.

Die Schablone 1 weist eine Druckseite 15 und eine Auflageseite 14 auf. Auf der Druckseite 15 weist die Schablone eine Nickelgewebestruktur auf, wodurch die Planarität der herzustellenden Konversionsplättchen gewährleistet wird.

Die Schablone 1 setzt sich also aus zwei Schichten zusammen, wobei die Schicht auf der Auflageseite eine formgebende Struktur und die Schicht auf der Druckseite eine Gitterstruktur aufweist. Die zwei Schichten der Schablone bestehen dabei vorzugsweise aus nur einem Material, bevorzugt Nickel, wodurch das Material der herzustellenden Konversionsplättchen optimiert werden kann.

Die doppelschichtige Schablone ist insbesondere ideal geeignet für Anwendungen, bei denen es auf eine hohe Genauigkeit ankommt und bietet mit Vorteil eine hohe Lebensdauer.

Mit der Auflageseite 14 steht die Schablone 1 in direktem Kontakt mit einem Substrat 2, wie in Figur 1A gezeigt. Das Substrat ist insbesondere geeignet, dass darauf die Konversionsplättchen angeordnet beziehungsweise hergestellt werden können. Das Substrat 2 ist auf einem Chuck, also einer Spannvorrichtung, angeordnet.

Das Substrat 2 ist insbesondere unterhalb der Durchbrüche 10 angeordnet, sodass die mittels der Durchbrüche 10 hergestellten Konversionsplättchen auf dem Substrat aufgedrückt werden können.

Auf der Druckseite 15 ist ein Grundmaterial 3 mit darin enthaltenem Konversionsstoff angeordnet. Das Grundmaterial 3 ist beispielsweise Silikon, wobei in dem Silikon ein Konversionsstoff eingebettet ist. Das Grundmaterial 3 ist dabei auf der Druckseite oberhalb der Durchbrüche der Schablone angeordnet und bedeckt diese vorzugsweise vollständig.

Um das Grundmaterial 3 mit darin enthaltenem Konversionsstoff nun mittels eines Druckprozesses durch die Durchbrüche 10 der Schablone 1 zu drücken, findet eine Druckrakel 7 Anwendung. Diese wird auf der Druckseite 15 entlang der lateralen Ausdehnung der Schablone 1 über die Druckseite geführt.

Wie in Figur 1B dargestellt, drückt die Druckrakel 7 während der lateralen Führung das Grundmaterial 3 mit darin enthaltenem Konversionsstoff in die Durchbrüche 10, insbesondere über die Gitterstruktur 12 in die formgebende Struktur 11. In dem Ausführungsbeispiel der Figur 1B ist das Grundmaterial 3 dabei bereits in zwei Durchbrüche 10 der Schablone 1 gedrückt, während das Grundmaterial 3 in den anderen zwei Durchbrüchen 10 mittels der Druckrakel 7 noch nicht hineingedrückt ist.

Während des Druckprozesses liegt die Schablone 1 mit der Auflageseite 14 weiter in direktem Kontakt auf dem Substrat 2 auf. Das Grundmaterial 3 wird somit in die Durchbrüche 10 während des Druckprozesses derart gedrückt, dass das Grundmaterial die formgebende Struktur 11 der Schablone bevorzugt vollständig ausfüllt, wobei das Grundmaterial auf dem Substrat in Bereichen der formgebenden Strukturen 11 aufgedrückt wird. Das Grundmaterial wird dabei über die Gitterstruktur zur formgebenden Struktur der Schablone geführt.

In Figur 1C ist der Druckvorgang mittels der Druckrakel 7 abgeschlossen, das heißt die Druckrakel 7 ist von der linken Seite über die Druckseite 15 vollständig bis zur rechten Seite der Schablone geführt. Dabei ist das Grundmaterial 3 in alle Durchbrüche 10 der Schablone 1 hineingedrückt worden. Das restliche Grundmaterial 3, also der Überschuss, wird dabei am Ende des Druckvorgangs bei der Druckrakel 7, im vorliegenden Ausführungsbeispiel auf der rechten Seite, gesammelt.
Nach Beendigung des Druckvorgangs wird die Schablone 1 von dem Substrat 2 abgehoben. Auf dem Substrat 2 bleiben die so hergestellten Konversionsplättchen 4 übrig. Die Form, Ausgestaltung und Größe der Konversionsplättchen 4 ist dabei vorgegeben durch die formgebende Struktur 11 der Schablone 1.

Durch ein Herstellungsverfahren mit einer doppelschichtigen Schablone mittels eines Druckverfahrens können Konversionsplättchen hergestellt werden, die eine größere Dicke D₂ aufweisen als Konversionsplättchen, die mit konventionellen Methoden, wie beispielsweise die Siebdrucktechnologie, hergestellt sind. Die Schichtdicke D₂ der Konversionsplättchen liegt dabei vorzugsweise in einem Bereich zwischen 60 µm und 170 µm, bevorzugt zwischen 90 µm und 110 µm. Die erhöhte Schichtdicke D₂ des Konversionsplättchens kann vorteilhafterweise für die Lichtkonversion eine größere Dichte des Konversionsstoffs im Grundmaterial aufweisen. Dadurch ist es vorteilhafterweise möglich, Farborte anzusteuern, die beispielsweise mit der konventionellen Herstellungstechnologie, wie beispielsweise der Siebdrucktechnologie, nicht realisierbar sind. Zudem ermöglicht sich mit einer erhöhten Schichtdicke der Konversionsplättchen 4 der Einsatz von Konversionsstoffen, die speziell in ihren Eigenschaften wie beispielsweise Effizienz, Temperaturstabilität oder Langzeitstabilität optimiert sind, und die herkömmlicherweise keinen Einsatz finden, beispielsweise aufgrund der Grenzen der Feststoffbeladung in dem Grundmaterial, die wiederum abhängig von der Dicke der Konversionsplättchen 4 sind.

Der Anteil des Konversionsstoffs im Grundmaterial beträgt vorzugsweise zwischen 55 Gew.-% und 70 Gew.-%.

Die Doppelschichtschablone trägt mit Vorteil zur Verbesserung der Kantentreue sowie zur Reproduzierbarkeit der Plättchenabmessungen bei. Insbesondere können so hinsichtlich ihrer Abmessungen und Kantentreue nahezu identische Konversionsplättchen 4 hergestellt werden.

Aufgrund der Nickelgewebestruktur der Schablone auf der Druckseite 15 kann die Oberfläche der Konversionsplättchen 4 beispielsweise eine Maschenstruktur aufweisen.

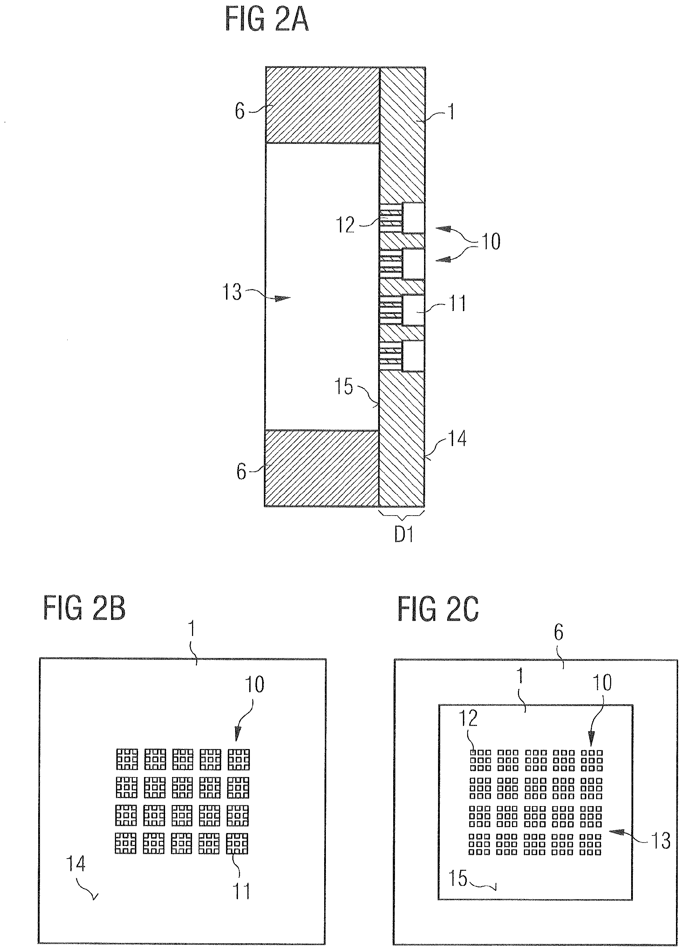

In den Figuren 2A bis 2C ist eine doppelschichtige Schablone 1 dargestellt, wie sie beispielsweise bei dem Verfahren zur Herstellung von einer Mehrzahl von Konversionsplättchen nach den Figuren 1A bis 1C Verwendung findet. Die Schablone 1 ist in einem zweistufigen Verfahren hergestellt, sodass diese einen zweischichtigen Aufbau aufweist. Die Schicht der Schablone 1 auf einer Auflageseite 14 weist formgebende Strukturen 11 auf. Diese sind im vorliegenden Ausführungsbeispiel beispielsweise als Quader oder Rechtecke ausgebildet. Die zweite Schicht auf der Druckseite 15 weist eine Gitterstruktur 12 auf.

Als Gitterstruktur ist insbesondere eine Struktur zu verstehen, die gitter- beziehungsweise matrixartig angeordnete Durchbrüche durch das Schablonenmaterial aufweist.

Die Gitterstruktur ist dabei jeweils einer formgebenden Struktur zugeordnet. Die formgebende Struktur 11 und die Gitterstruktur 12 sind derart ausgebildet, dass sie ineinander übergehen. Somit durchbricht die Schablone im Bereich der Durchbrüche 10 teilweise vollständig. Die Schablone 1 weist dabei eine Mehrzahl von Einheiten aus formgebender Struktur 11 und Gitterstruktur 12 auf.

Die Schablone 1 ist mittels eines Spannrahmens 6 eingespannt. Der Spannrahmen 6 bildet eine Ausnehmung 13 auf der Druckseite 15 aus, in die zur Herstellung der Konversionsplättchen das Grundmaterial mit darin enthaltenem Konversionsstoff angeordnet wird. Das Grundmaterial bedeckt dabei vollständig die Gitterstrukturen der Schablone 1.

In Figur 2B ist eine Aufsicht auf die Auflageseite 14 der Schablone 1 dargestellt. Die Schablone 1 ist vorliegend quadratisch ausgebildet und weist matrixartig angeordnete Durchbrüche 10 auf. Jeweils ein Durchbruch 10 setzt sich zusammen aus einer formgebenden Struktur 11 und darüber angeordneten Gitterstrukturen. Von der Auflageseite sind insbesondere die formgebenden Strukturen 11 sichtbar, wobei die Gitterstrukturen durch die formgebenden Strukturen hindurch erkennbar sind. Die Auflageseite 14 der Schablone 1 ist vorzugsweise planar ausgebildet, weist somit eine planare Fläche auf, mit der die Schablone 1 auf dem Substrat angeordnet wird.

In Figur 2C ist eine Aufsicht auf die Druckseite 15 der Schablone 1 gezeigt. Die Schablone 1 wird insbesondere mittels eines rahmenförmig angeordneten Spannrahmens 6 stabilisiert. Der Spannrahmen 6 ist dabei derart im Randbereich der Schablone 1 angeordnet, dass in einem mittigen Bereich der Schablone, insbesondere in dem Bereich, in dem die Durchbrüche 10 angeordnet sind, eine Ausnehmung 13 ausgebildet wird. Auf der Druckseite sind die Gitterstrukturen 12 sichtbar, die oberhalb der formgebenden Strukturen matrixartig angeordnet sind. Jede Gitterstruktur setzt sich dabei aus einer Mehrzahl von Durchbrüchen zusammen, die gitterartig angeordnet sind, wobei jeweils ein Durchbruch der Gitterstruktur eine geringere laterale Ausdehnung als die formgebende Struktur aufweist, sodass über jeder formgebenden Struktur eine Mehrzahl von matrixartig angeordneten Durchbrüchen der Gitterstruktur angeordnet sind. In die Ausnehmung 13 wird zur Herstellung der Konversionsplättchen das Grundmaterial mit darin enthaltenem Konversionsstoff angeordnet und mittels einer Druckrakel in die Durchbrüche hineingedrückt.

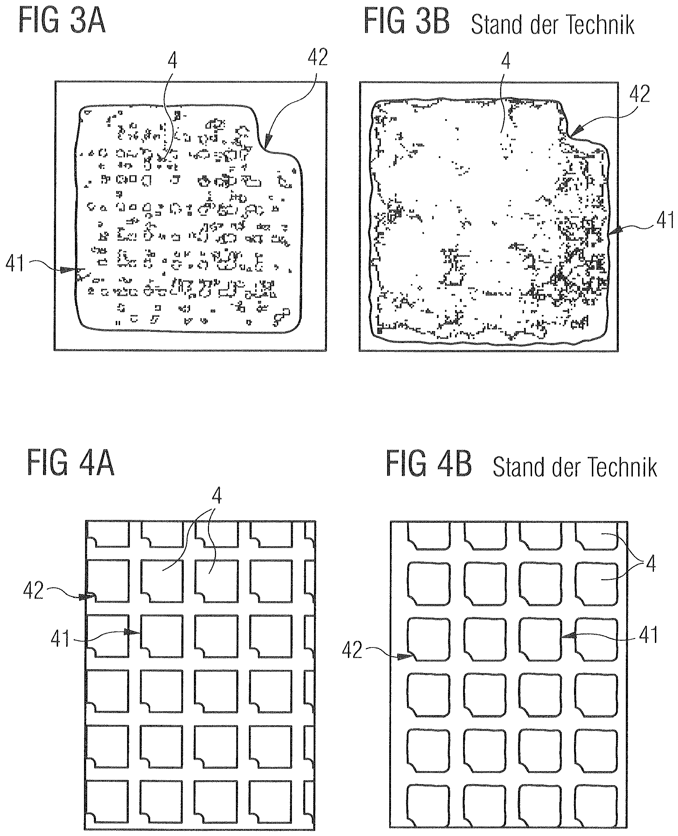

In den Figuren 3A und 3B ist ein Vergleich eines Konversionsplättchens dargestellt, das mittels eines erfindungsgemäßen Verfahrens hergestellt ist, siehe Figur 3A, beziehungsweise das mit einem herkömmlicherweise verwendeten Siebdruckverfahren hergestellt ist, siehe Figur 3B. Insbesondere ist jeweils eine Aufsicht auf ein Konversionsplättchen 4 gezeigt.

Wie in Figur 3A dargestellt, weist ein mittels einer Doppelschichtschablone gedruckten Konversionsplättchen 4 eine scharfkantige Kontur auf. Die Kanten 41 sind dabei also scharf ausgebildet. Im Vergleich dazu weist ein Konversionsplättchen 4 hergestellt nach dem Stand der Technik nachteilig wellenförmige Kanten 41 auf.

Die Konversionsplättchen 4 der Figuren 3A und 3B weisen jeweils eine Ausnehmung 42 auf, die in einem vorgesehenen Bondpadbereich eines strahlungsemittierenden Halbleiterbauelements angeordnet sind.

In den Figuren 4A und 4B sind jeweils eine Mehrzahl von Konversionsplättchen 4 gezeigt, die einmal nach dem erfindungsgemäßen Verfahren und einmal nach dem Stand der Technik hergestellt sind. Wie in Figur 4A dargestellt, sind die Bondpadbereiche der mit der Doppelschichtschablone gedruckten Konversionsplättchen 4 jeweils sehr ähnlich geformt, nahezu identisch ausgebildet. Insbesondere weisen die Form, Ausgestaltung, Größe und Kanten der Konversionsplättchen 4 voneinander kaum Abweichungen auf. Im Gegensatz dazu ist die Form der Bondpadbereiche der siebgedruckten Konversionsplättchen 4 sowie deren Form, Ausgestaltung, Größe und Kanten sehr unterschiedlich ausgestaltet, wie in Figur 4B dargestellt. Die unterschiedliche Ausbildung ist insbesondere durch die Maskierung des Siebes vorgegeben.

## Patentansprüche

1. Verfahren zur Herstellung zumindest eines Konversionsplättchens (4) für ein strahlungsemittierendes Halbleiterbauelement, bei dem ein Grundmaterial (3) mit einem darin enthaltenen Konversionsstoff mittels einer doppelschichtigen Schablone (1) auf ein Substrat (2) aufgebracht wird,
**dadurch gekennzeichnet, dass**
die Schablone (1) Durchbrüche (10) aufweist, wobei die Durchbrüche (10) zwei Bereiche aufweisen, die vertikal übereinander angeordnet sind, wobei der dem Substrat (2) zugewandte formgebende Bereich (11) die Form des herzustellenden Konversionsplättchens (4) wiedergibt und der von dem Substrat (2) abgewandte Bereich zur Stabilisierung der Schablone (1) eine Gitterstruktur (12) aufweist, wobei sich jede Gitterstruktur (12) aus einer Mehrzahl von Strukturdurchbrüchen zusammensetzt, die gitterartig angeordnet sind und jeweils ein Strukturdurchbruch der Gitterstruktur (12) eine geringere laterale Ausdehnung als der formgebende Bereich (11) aufweist, sodass über jedem formgebenden Bereich (11) eine Mehrzahl von matrixartig angeordneten Strukturdurchbrüchen der Gitterstruktur (12) angeordnet ist.

2. Verfahren nach Anspruch 1, wobei
das Grundmaterial (3) mit darin enthaltenem Konversionsstoff mittels eines Druckverfahrens aufgebracht wird.

3. Verfahren nach einem der vorhergehenden Ansprüche, wobei
die Schablone (1) eine dem Substrat (2) abgewandte Druckseite (15) und eine dem Substrat (2) zugewandte Auflageseite (14) aufweist, die in direktem Kontakt mit dem Substrat (2) ist, und wobei
der Durchbruch (10) die Schablone (1) vollständig durchbricht,
und wobei das Grundmaterial (3) mit darin enthaltenem Konversionsstoff durch die Strukturdurchbrüche in den an das Substrat (2) grenzenden formgebenden Bereich (11) aufgedrückt wird, sodass die Durchbrüche (10) vollständig mit dem Grundmaterial gefüllt sind, und wobei der formgebende Bereich (11) auf der Auflageseite (14) die Form des Konversionsplättchens (4) bestimmt.

4. Verfahren nach Anspruch 3, wobei
die Druckseite (15) eine Nickel-Gewebestruktur aufweist.

5. Verfahren nach Anspruch 3 oder 4, wobei
das Grundmaterial (3) mit darin enthaltenem Konversionsstoff auf der Druckseite (15) aufgebracht wird und anschließend durch die Schablone (1) mittels einer Druckrakel (7) auf das Substrat (2) aufgedrückt wird.

6. Verfahren nach einem der vorhergehenden Ansprüche, wobei
die Schablone (1) beim Aufbringen des Grundmaterials (3) in direktem Kontakt mit dem Substrat (2) angeordnet wird.

7. Verfahren nach einem der vorhergehenden Ansprüche, bei dem
das Konversionsplättchen (4) mit einer Dicke zwischen einschließlich 60 µm und einschließlich 170 µm hergestellt wird.

8. Verfahren nach einem der vorhergehenden Ansprüche, wobei in einem gemeinsamen Verfahren eine Mehrzahl von Konversionsplättchen (4) hergestellt wird, die in einem gemeinsamen Verfahrensschritt auf das Substrat (2) mittels eines Druckverfahrens aufgebracht werden.

9. Verfahren nach Anspruch 8, wobei
die Schablone (1) eine Mehrzahl von Durchbrüchen (10) aufweist, durch die jeweils die Form eines Konversionsplättchen (4) bestimmt wird.

10. Verfahren nach Anspruch 9, wobei die Mehrzahl von Durchbrüchen (10) matrixartig angeordnet ist, und wobei die Durchbrüche (10) identisch ausgebildet sind, sodass die Konversionsplättchen (4) nahezu identisch ausgebildet werden.

11. Verfahren nach den Ansprüchen 1, 3 und 7, wobei
das Substrat (2) und das Konversionsplättchen (4) frei sind von einem strahlungsemittierenden Halbleiterbauelement.

12. Verfahren nach einem der vorhergehenden Ansprüche, wobei
das Substrat (2) ein Foliensubstrat ist, das auf einer Spannvorrichtung angeordnet ist.

## Claims

1. A method of producing at least one conversion plate (4) for a radiation-emitting semiconductor device, in which a base material (3) with a conversion material contained therein is applied to a substrate (2) by means of a double-layer stencil (1), **characterized in that**
the stencil (1) has apertures (10), the apertures (10) having two regions which are arranged vertically one above the other, wherein the shaping region (11) facing the substrate (2) reproduces the shape of the conversion plate (4) to be produced and the region facing away from the substrate (2) has a lattice structure (12) for stabilising the stencil (1), wherein each lattice structure (12) is composed of a plurality of structural openings which are arranged in a lattice-like manner and in each case one structural opening of the lattice structure (12) has a smaller lateral extent than the shaping region (11), so that a plurality of structural openings of the lattice structure (12) arranged in a matrix-like manner are arranged above each shaping region (11) .

2. The method according to claim 1, wherein
the base material (3) with conversion material contained therein is applied by means of a pressure process.

3. The method according to any one of the preceding claims, wherein the stencil (1) has a printing side (15) facing away from the substrate (2) and a support side (14) facing the substrate (2) being in direct contact with the substrate (2), and wherein the aperture (10) completely breaks through the stencil (1), and wherein the base material (3) with conversion material contained therein is pressed through the structural apertures into the shaping region (11) adjoining the substrate (2) so that the apertures (10) are completely filled with the base material, and wherein the shaping region (11) on the support side (14) determines the shape of the conversion plate (4).

4. The method according to claim 3, wherein
the printing side (15) has a nickel fabric structure.

5. The method according to claim 3 or 4, wherein
the base material (3) with conversion material contained therein is applied to the printing side (15) and then pressed through the stencil (1) onto the substrate (2) by means of a squeegee (7).

6. The method according to one of the preceding claims, wherein the stencil (1) is placed in direct contact with the substrate (2) when applying the base material (3).

7. The method according to any one of the preceding claims, wherein the conversion plate (4) is produced with a thickness between 60 µm and 170 µm inclusive.

8. The method according to any one of the preceding claims, wherein in a common process, a plurality of conversion plates (4) is produced, which are applied to the substrate (2) in a common process step by means of a printing process.

9. The method according to claim 8, wherein
the stencil (1) has a plurality of apertures (10), through each of which the shape of a conversion plate (4) is determined.

10. The method according to claim 9, wherein the plurality of apertures (10) is arranged in a matrix-like manner, and wherein the apertures (10) are formed identically, so that the conversion plates (4) are formed almost identically.

11. The method according to claims 1, 3 and 7, wherein
the substrate (2) and the conversion plate (4) are free of a radiation emitting semiconductor device.

12. The method according to any one of the preceding claims, wherein the substrate (2) is a film substrate arranged on a chuck.

## Revendications

1. Procédé de fabrication d'au moins une plaquette de conversion (4) pour un dispositif semi-conducteur émettant de rayonnement, dans lequel un matériau de base (3) avec un matériau de conversion contenu dans celui-ci est appliqué sur un substrat (2) au moyen d'un gabarit à double couche (1), **caractérisé en ce que**
le gabarit (1) présente des ouvertures (10), les ouvertures (10) présentant deux zones qui sont disposées verticalement l'une au-dessus de l'autre, la zone de façonnage (11) tournée vers le substrat (2) reproduisant la forme de la plaquette de conversion (4) à produire, et la zone détournée du substrat (2) présentant une structure en treillis (12) pour stabiliser le gabarit (1), dans lequel chaque structure en treillis (12) est composée d'une pluralité d'ouvertures structurelles qui sont disposées à la manière d'un treillis et à chaque fois une ouverture structurelle de la structure en treillis (12) a une étendue latérale plus petite que la région de façonnage (11), de sorte qu'une pluralité d'ouvertures structurelles de la structure en treillis (12) disposées à la manière d'une matrice sont disposées au-dessus de chaque région de façonnage (11).

2. Procédé selon la revendication 1, dans laquelle le matériau de base (3) avec un matériau de conversion contenu dans celui-ci est appliqué au moyen d'un processus de pression.

3. Procédé selon l'une des revendications précédentes, dans lequel le gabarit (1) a un côté d'impression (15) détourné du substrat (2) et un côté de support (14) tourné vers le substrat (2) et en contact direct avec le substrat (2), et dans lequel l'ouverture (10) traverse complètement le gabarit (1) et dans lequel le matériau de base (3) avec un matériau de conversion contenu dans celui-ci est pressé à travers les ouvertures structurelles dans la zone de façonnage (11) adjacente au substrat (2) de sorte que les ouvertures (10) sont complètement remplies avec le matériau de base, et dans lequel la zone de façonnage (11) sur le côté de support (14) détermine la forme de la plaquette de conversion (4).

4. Procédé selon la revendication 3, dans laquelle la face d'impression (15) comprend une structure en tissu de nickel.

5. Procédé selon la revendication 3 ou 4, dans lequel le matériau de base (3) avec un matériau de conversion contenu dans celui-ci est appliqué sur la face d'impression (15) et ensuite pressé à travers le gabarit (1) sur le substrat (2) au moyen d'une barre d'impression (7).

6. Procédé selon l'une des revendications précédentes, dans lequel le gabarit (1) est disposé en contact direct avec le substrat (2) lors de l'application du matériau de base (3).

7. Procédé selon l'une des revendications précédentes, dans lequel la plaquette de conversion (4) est produite avec une épaisseur comprise entre 60 µm et 170 µm inclus.

8. Procédé selon l'une des revendications précédentes, dans lequel une pluralité de plaquettes de conversion (4) sont produites dans un proceed commun, qui sont appliquées sur le substrat (2) au moyen d'un procédé d'impression.

9. Procédé selon la revendication 8, dans laquelle le gabarit (1) présente une pluralité d'ouvertures (10), au moyen desquel la forme d'une plaquette de conversion (4) est déterminée respectivement.

10. Procédé selon la revendication 9, dans lequel la pluralité d'ouvertures (10) est disposée à la manière d'une matrice, et dans lequel les ouvertures (10) sont formées de manière identique de sorte que les plaquettes de conversion (4) sont formées de manière presque identique.

11. Procédé selon les revendications 1, 3 et 7, dans lequel le substrat (2) et la plaquette de conversion (4) sont exempts d'un dispositif semi-conducteur émettant de rayonnement.

12. Procédé selon l'une des revendications précédentes, dans lequel le substrat (2) est un substrat de film disposé sur un châssis.
